# EUROPÄISCHE PATENTANMELDUNG

(11) **EP 1 211 719 A1**
(43) Veröffentlichungstag der Anmeldung: **05.06.2002**
(21) Anmeldenummer: 01127347.1
(22) Anmeldetag: 21.11.2001
(51) Int. Cl.: H01L 21/321, H01L 21/304, C09G 1/02, C09K 3/14

(54) **Poliersuspension für das chemisch-mechanische Polieren von Metall- und Dielektrikastrukturen**

(30) Priorität: 04.12.2000 DE 10060343
(71) Anmelder: BAYER AG, 51368 Leverkusen (DE)
(72) Erfinder: Vogt, Kristina, Dr., 51061 Köln (DE); Passing, Gerd, Dr., 50937 Köln (DE); Tsai, Ming-Shih, Dr., Nantz Chiu, Kaohsiung 811 (TW)

(57) **Zusammenfassung**

Eine Polierslurry für das chemisch-mechanische Polieren von Metall- und Metall/Dielektrika-Strukturen, enthaltend 2,5 bis 70 Vol.-% eines durch H⁺- oder K⁺-Ionen stabilisierten 15 bis 40 Gew.-% SiO₂ enthaltenden Kieselsols, dessen SiO₂- Partikel eine mittlere Teilchengröße kleiner als 300 nm haben, 6 bis 10 Vol.-% Wasserstoffperoxid und eine Base in einer Menge um den pH-Wert bei 22°C der Polierslurry auf einen Wert von 5 bis 11,5 einzustellen hat eine Ta-Abtragsrate >300 Å/min und eine verbesserte Selektivität.

## Beschreibung

Die vorliegende Erfindung betrifft eine Polierslurry für das chemisch-mechanische Polieren (CMP) von Metall- und Dielektrikastrukturen, ein Verfahren zu ihrer Herstellung und ihre Verwendung.

Für die Herstellung von integrierten Schaltungen (Integrated Circuits, IC) wird zunehmend der sogenannte Cu-Damascene-Prozess verwendet (Microchip Fabrication: A Practical Guide to Semiconductor Processing, Peter Van Zant, 4^{th} ed., McGraw-Hill, 2000, pp 401 - 403 und 302 - 309 und Copper CMP: A Question of Tradeoffs, Peter Singer, Semiconductor International, Verlag Cahners, Mai 2000, pp 73 - 84). Dabei ist es erforderlich, eine Cu-Schicht chemisch-mechanisch mit einer Polierslurry abzutragen (sog. Cu-CMP-Prozess), um die Cu-Leiterbahnen herzustellen. Die fertigen Cu-Leiterbahnen sind in ein Dielektrikum eingebettet. Zwischen Cu und dem Dielektrikum befindet sich eine Barriereschicht. Stand der Technik für den Cu-CMP-Prozess ist ein Zwei-Schritt Prozess. D. h., dass die Cu-Schicht zuerst mit einer Polierslurry poliert wird, die einen hohen Cu-Abtrag garantiert. Anschließend wird eine zweite Polierslurry verwendet, um die endgültige ebene Oberfläche mit dem blank polierten Dielektrikum und den eingebetteten Leiterbahnen herzustellen. Ein Wafer ist eine polierte Siliciumscheibe, auf der integrierte Schaltungen aufgebaut werden.

Für den ersten Polierschritt verwendet man eine Polierslurry mit hoher Selektivität, d. h., dass die Abtragsrate für Cu möglichst hoch ist und die für das Material der darunter liegenden Barriereschicht möglichst klein ist. Der Polierprozess wird automatisch gestoppt, sobald unter dem Cu die Barriereschicht freigelegt wird. Da das komplette Entfernen von Cu-Resten auf der Barriereschicht einige Zeit dauert (sogenanntes "over polishing"), wird an den Stellen, wo sich im Dielektrikum die eingebetteten Cu-Leiterbahnen befinden, in dieser Zeit das Cu der Leiterbahn weiterhin stark abgetragen. Dieser Effekt wird "dishing" genannt. Für den zweiten Polierschritt verwendet man, je nach Konzept, eine Polierslurry, die selektiv oder nicht selektiv ist, bezüglich der zu polierenden Materialien Cu, Barriereschicht und Dielektrikum.

Bei Verwendung einer nicht selektiven Polierslurry, d.h. bei annähernd gleicher Abtragsrate für Cu, Barriereschicht und Dielektrikum, wird die gesamte Waferoberfläche durch den Polierprozess eingeebnet (planarisiert), einschließlich des sog. "dishing" an der Oberfläche der Cu-Leiterbahnen, das während der Cu-Polierung im ersten Polierschritt verursacht wurde. Bei diesem Konzept muss ein Teil der Dielektrikaschicht geopfert werden, was wegen der notwendigen Abscheidung dickerer Dielektrika- und Cu-Schichten nachteilig ist. Kritischer Punkt bei Verwendung der nicht selektiven Polierslurry ist, dass die Polierslurry eine für alle drei zu polierenden Materialien die gleiche Planarisierungseffektivität haben muss. Außerdem müssen die hergestellten Cu-Leiterbahnen eine Mindestdicke aufweisen, d. h. es darf nicht zu viel von der Dielektrikaschicht und den Cu-Leiterbahnen geopfert werden, was während des Polierprozesses kontrolliert werden muss.

Bei Verwendung einer selektiven Polierslurry ist die Abtragsrate für die Barriereschicht höher ist als die des Cu. Bei diesem Konzept wird durch das gezielte Abtragen der Barriereschicht das sogenannte "dishing" der Cu-Leiterbahnen verringert. Der Verlust an Dielektrikum und damit einhergehend der Cu-Leiterbahn-Schichtdicke ist daher geringer. Entsprechende Beispiele sind in WO 00/00567 und WO 99/64527 offenbart. In den Beispielen sind Polierslurries mit Selektivitäten für Cu : Ta: Dielektrikum (hier ein SiO₂, auch Oxid genannt) von 1 : 4,5 : 2 und 1 : 1,6 : 4 angegeben. Die Polierslurry aus WO 99/64527 führt zu einem sehr starken Abtrag des Oxids, sobald die Barriereschicht abpoliert ist und damit zu einer unebenen Waferoberfläche. Die sogenannte "oxide erosion" wird sogar verstärkt. Der Begriff "oxide erosion" wird in Copper CMP: A Question of Tradeoffs, Peter Singer, Semiconductor International, Verlag Cahners, Mai 2000, pp 73 - 84 beschrieben. Nur mit der in WO 00/00567, Beispiel 3, Nr. 3 beschriebenen Polierslurry mit Aluminiumoxid als Schleifinittel (Abrasiv) wird ein Selektivitätsverhältnis Cu : Ta : Oxid von 1 : 4,5 : 2 erzielt, mit dem die beschriebenen Nachteile vermieden werden. Nachteil dieser Polierslurry ist die niedrige Abtragsrate für die Barriereschicht aus Ta von 300 Å/min, die den Produktionsprozess verlangsamt, und die hohe Härte des Aluminiumoxids, was verstärkt zu Kratzern auf der Waferoberfläche führt (Chemical Mechanical Planarization of Microelectronic Materials, J.M. Steigerwald, S. P. Murarka, R. J. Gutmann, John Wiley & Sons, Inc. 1997, pp 42 - 43).

Die in den Beispielen von WO 99/64527 aufgeführten Polierslurries weisen folgende Abtragsraten (auch "removal rate" genannt, abgekürzt RR) und Selektivitäten auf:

**Tabelle1**

| Beispiel (Tabelle) | Probe | H₂O₂ / Gew.-% | H₂O₂ / Vol.-% | pH | RR Cu | RR Ta | RR SiO₂ | Selektivität Cu: Ta: SiO₂ |
|---|---|---|---|---|---|---|---|---|
| 3 | 3 | 2 | 1,38 | 2,5 | 866 | 372 | - | 1 : 0,43 : - |
| 3 | 4 | 2 | 1,38 | 6 | 256 | 312 | - | 1 : 1,22 : - |
| 3 | 2 | 2 | 1,38 | 10,5 | 314 | 495 | 1261 | 1 : 1,58 : 4,02 |

In Polierslurries verwendete Abrasive sind z.B. Aluminiumoxid (WO 00/00567 und WO 99/47618). WO 99/67056 verwendet ein mit Aluminat-Ionen modifiziertes Kieselsol, das mit Na-Ionen stabilisiert ist. Na-Ionen in der flüssigen Phase von Polierslurries für das chemisch-mechanische Polieren von integrierten Schaltungen sind generell nicht erwünscht. WO 00/24842 verwendet sogenannte pyrogene Kieselsäure, WO 99/64527 setzt Kieselsol ein. TiO₂ wird in WO 99/64527 genannt.

Außerdem werden weitere Zusätze verwendet, um die Abtragsraten der Metalle zu erhöhen, bzw. um die Selektivität der Polierslurry einzustellen. Hier sind Oxidationsmittel, Carboxylsäuren und Komplexbildner bekannt. Aus WO 99/64527 und WO 99/67056 ist bekannt, dass Kieselsole im basischen Medium hohe Oxidabtragsraten bewirken, was bei der reinen Oxidpolierung Stand der Technik ist.

WO 99/64527 setzt Polyvinylpyrrolidone (PVP) zur Polierslurry zu, um die Oxidabtragsrate zu senken.

Die genannten Polierslurries weisen allerdings den Nachteil auf, dass die Selektivitäten, insbesondere die von Cu : Oxid, über den Zusatz von z.B. Filmbildnern oder organischen Verbindungen eingestellt werden und die vom Abrasiv und pH-Wert vorgegebene Cu : Oxid-Selektivität nicht geeignet ist.

Alle genannten Polierslurries enthalten H₂O₂ als Oxidationsmittel, um die Abtragsraten der Metalle zu erhöhen.

Der Begriff Metall umfasst die Elemente W, Al, Cu, Ru, Ta, Ti, Pt und Ir und/oder deren Legierungen, Nitride, Carbide, Oxide, Carbonitride, Oxinitride, Oxicarbide und Oxicarbonitride.

Der Begriff Dielektrikum umfasst organische und nicht organische Dielektrika. Beispiele für organische Dielektrika sind SiLK™ der Dow Chemical Company, Polyimide, fluorierte Polyimide, diamantartige Kohlenstoffe, Polyarylether, Polyarylene, Parylen N, Cyclotene, Polynorbonene und Teflon. Nichtorganische Dielektrika basieren z.B. auf SiO₂-Glas als Hauptbestandteil. Nebenbestandteile können Fluor-, Phosphor- und/oder Bor-Verbindungen sein. Gebräuchliche Bezeichnungen für diese Dielektrika sind z.B. FSG, PSG, BSG oder BPSG, wobei SG für "spin on glass" steht. Für die Herstellung dieser Schichten sind verschiedene Herstellungsverfahren bekannt (Peter Van Zant, 4^{th} ed., McGraw-Hill, 2000, pp 363 - 376 und pp 389 - 391). Außerdem sind Silsesquioxane (HSQ, MSQ) als Dielektrika bekannt, die stark polymerisiert sind und dem anorganischen Zustand angenähert wurden.

Der Begriff Barriereschicht umfasst Schichten aus Ta, TaSi, TaN, TaSiN, Ti, TiN, WN, WSiN, SiC, Siliciumoxinitrid, Siliciumoxicarbid, Siliciumoxicarbonitrid, Si₃N₄ und/oder Siliciumoxid.

Es bestand daher die Aufgabe, eine Polierslurry bereitzustellen mit einer Ta-Abtragsrate > 300 Å/min, mit einer Selektivität von Cu : Ta von 1 : 2 oder größer und einer Selektivität von Cu : Dielektrikum von 1 : 1 oder größer, wobei die Abtragsrate des Ta ≥ des 1,15-fachen der Abtragsrate des Dielektrikums ist.

Überraschend wurde nun gefunden, dass diese Aufgabe mit einer Polierslurry gelöst wird, die ein Kieselsol als Abrasiv, ein Oxidationsmittel und eine Base enthält.

Gegenstand der Erfindung ist daher eine Polierslurry für das chemisch-mechanische Polieren von Metall- und Metall/Dielektrika-Strukturen enthaltend 2,5 bis 70 Vol.-% eines durch H⁺- oder K⁺-Ionen stabilisierten 15-40 Gew.-% SiO₂ enthaltenden Kieselsols, dessen SiO₂-Partikel eine mittlere Teilchengröße kleiner als 300 nm haben, 6 bis 10 Vol.-% Wasserstoffperoxid und eine Base in einer Menge um den pH-Wert bei 22°C der Polierslurry auf einen Wert von 5 bis 11,5 einzustellen.

Vorzugsweise enthält das stabilisierte Kieselsol 20 bis 35 Gew.-% SiO₂, besonders bevorzugt 25 bis 35 Gew.-%, insbesondere bevorzugt 28 bis 32 Gew.-%, ganz besonders bevorzugt 30 Gew.-%.

Kieselsol im Sinne der Erfindung ist ein Sol, dessen kolloidale SiO₂-Partikel anionisch stabilisiert sind. Kationen im Sinne der Erfindung sind H⁺- und K⁺-Ionen. Die Primärpartikel des Kieselsols sind nicht aggregiert. Die mittlere Teilchengröße der SiO₂-Partikel im Kieselsol ist kleiner als 300 nm, bevorzugt hat die mittlere Teilchengröße einen Wert von 50 bis 90 nm. Die erfindungsgemäße Polierslurry enthält vorzugsweise 1 bis 21,5 Gew.-% SiO₂. Ein H⁺-stabilisiertes Kieselsol hat einen typischen pH-Wert bei 22°C von 1,5 bis 2,5. Bei höheren pH-Werten wird H⁺ durch K⁺ ersetzt, wobei der Übergang fließend ist. Ein Kieselsol mit pH 7 bei 22°C oder größer gilt als K⁺-stabilisiert.

Die mittlere Teilchengröße wird in einer Ultrazentrifuge durch Sedimentation im Schwerefeld bestimmt.

In einer bevorzugten Ausführungsform der Erfindung enthält die Polierslurry 8 bis 10 Vol.-% Wasserstoffperoxid. Wegen der leichteren Handhabbarkeit kann die erfindungsgemäße Polierslurry auch mit verdünnten Wasserstoffperoxid-Lösungen hergestellt werden.

Der pH-Wert bei 22°C der Polierslurry liegt im Bereich von 5 bis 11,5. Bevorzugt ist der Bereich von 6 bis 10 und ganz besonders bevorzugt der Bereich von 7 bis 9. Die erfindungsgemäße Polierslurry enthält vorzugsweise als Base Kaliumhydroxid. Der pH-Wert der Polierslurry wird vorzugsweise durch Zugabe einer wässrigen Lösung von Kaliumhydroxid zum Kieselsol eingestellt. Die erfindungsgemäße Polierslurry enthält vorzugsweise 0,001 bis 30 g/l Kaliumhydroxid (100-%ig).

Der Polierslurry können Korrosionsschutzmittel für die Metalle zugesetzt werden, wie zum Beispiel Benztriazolamin.

Der Polierslurry können ausserdem Komplexbildner für die Metalle zugesetzt werden, die die Metalle wasserlöslich machen, wie zum Beispiel Zitronensäure oder Citrate.

Gegenstand der Erfindung ist weiterhin ein Verfahren zur Herstellung einer Polierslurry für das chemisch-mechanische Polieren von Metall- und Metall/Dielektrika-Strukturen, enthaltend 2,5 bis 70 Vol.-% eines durch H⁺- oder K⁺-Ionen stabilisierten 15 bis 40 Gew.-% SiO₂ enthaltenden Kieselsols, dessen SiO₂-Partikel eine mittlere Teilchengröße kleiner als 300 nm haben, 6 bis 10 Vol.-% Wasserstoffperoxid und eine Base in einer Menge um den pH-Wert bei 22°C der Polierslurry auf einen Wert von 5 bis 11,5 einzustellen, dadurch gekennzeichnet ist, dass beim Vermischen der Bestandteile die Zugabe des Wasserstoffperoxids zuletzt erfolgt.

Wird für die Herstellung der Polierslurry ein mit H⁺-Ionen stabilisiertes Kieselsol eingesetzt, dann kann dieses durch Zugabe von KOH in ein K⁺-stabilisiertes Kieselsol überführt werden. Nach Zugabe von KOH ist das Kieselsol so lange zu rühren, bis sich ein Gleichgewicht der Anionen auf der Kieselsoloberfläche eingestellt hat. Zweckmäßigerweise liegt das KOH in gelöster Form vor.

Der pH-Wert der Polierslurry wird vorzugsweise durch Zugabe von Kaliumhydroxid zum Kieselsol eingestellt, bevor die Wasserstoffperoxid-Zugabe erfolgt. Nach der Zugabe von Kaliumhydroxid ist das Kieselsol so lange zu rühren, bis sich der pH-Wert stabilisiert hat. Zur Herstellung von Polierslurries mit einem pH-Wert bei 22°C <6 wird bevorzugt ein Kieselsol mit einem pH-Wert bei 22°C von 1,5 bis 2,5 verwendet. Zur Herstellung von Polierslurries mit einem pH-Wert bei 22°C >6 wird bevorzugt ein Kieselsol mit einem pH-Wert bei 22°C von 7 oder größer verwendet.

Die Zugabe des Wasserstoffperoxids zum Kieselsol erfolgt vorzugsweise direkt vor der Verwendung der Polierslurry, wobei auf ausreichende Vermischung zu achten ist. Dies kann beispielsweise durch geeignete Mischdüsen geschehen. Bevorzugt wird eine Vermischung direkt am Ort der Verwendung durchgeführt, d.h. kurz bevor die gebrauchsfertige Polierslurry auf das Poliertuch aufgebracht wird.

Gegenstand der Erfindung ist weiterhin die Verwendung der erfindungsgemäßen Polierslurry bei der Herstellung von Halbleitern, integrierten Schaltungen und microelektromechanischen Systemen.

Bei den zu polierenden Metallen handelt es sich vorzugsweise um Al, Ru, Pt, Ir, Cu, Ta, Ti, Si und W und/oder deren Legierungen, Nitride, Carbide, Oxide, Carbonitride, Oxinitride, Oxicarbide und Oxicarbonitride, wobei auch zwei oder mehr der genannten Elemente vorhanden sein können.

Bei den zu polierenden Dielektrika handelt es sich vorzugsweise um SiLK™, Polyimide, fluoriertes Polyimid, diamantartige Kohlenstoffe, Polyarylether, Polyarylene, Parylen N, Cyclotene, Polynorbonene, Teflon, Silsesquioxane, SiO₂-Glas oder um SiO₂-Glas als Hauptkomponente mit den Nebenkomponenten Fluor, Phosphor und/oder Bor.

Bei den zu polierenden Barriereschichten handelt es sich vorzugsweise um Schichten aus Ta, TaSi, TaN, TaSiN, Ti, TiN, WN, WSiN, SiC, Siliciumoxinitrid, Siliciumoxicarbid, Siliciumoxicarbonitrid, Si₃N₄ und/oder Siliciumoxid.

### Beispiele

Die Polierexperimente wurden mit dem Polierer IPEC 372M der Fa. Westech, USA durchgeführt. Die Polierparameter sind in Tabelle 2 aufgeführt. Es wurden 150 mm Wafer mit Beschichtungen aus Cu, Ta und SiO₂ poliert. Cu und Ta wurden mit einem PVD-Verfahren (physikalische Dampfphasenabscheidung) abgeschieden, das SiO₂ durch Oxidation des Si-Wafers erzeugt.

**Tabelle 2**

| Polierer: ***IPEC 372M*** | |
|---|---|
| Arbeitsscheiben- (Poliertuch-) Drehzahl | 45 U/min |
| Polierkopf- (Wafer-) Drehzahl | 42 U/min |
| Anpreßdruck | 34,5 kPa (5.0 psi) |
| Rückseitendruck | 13,8 kPa (2.0 psi) |
| Slurry-Flussrate | 150 ml/min |
| Poliertuch | Rodel Politex Regular E. TM |

Die Polierslurries wurden wie folgt angesetzt:
30 Vol.- % eines 30 Gew.-% SiO₂ enthaltenden Kieselsols wurden unter Rühren mit 70 Vol.-% einer Lösung, bestehend aus 30 Gew.-%iger H₂O₂-Lösung und destilliertem Wasser, verdünnt. Es wurde 10 Minuten nachgerührt. Der resultierende SiO₂-Gehalt beträgt 10 Gew.-%. Die für die Versuche benötigte Menge von 1 bis 10 Vol.-% an H₂O₂ (100 %-ig) bezieht sich auf das gesamte Volumen, bestehend aus Kieselsol, 30 %-iger H₂O₂-Lösung und destilliertem Wasser. Die Dichte der Polierslurry beträgt ca. 1,1 g/cm³. Anschließend wurde unter starkem Rühren der gewünschte pH-Wert der Polierslurry mit fester KOH eingestellt. Es wurde 60 Minuten nachgerührt.

### Beispiel 1

In dieser Versuchsreihe wurden Polierslurries mit 1, 3, 6 und 10 Vol.-% H₂O₂ hergestellt. Anschließend wurden die angegebenen Mengen KOH zugegeben, um einen pH-Wert bei 22°C von 10 zu erhalten, und eine Stunde gerührt. Nach der Herstellung der Polierslurries wurden die Wafer direkt poliert. Die KOH-Gehalte (100 %-ig, bezogen auf 1 Liter Polierslurry ohne KOH-Zusatz) und die Abtragsraten sind in Tabelle 3 aufgeführt.

Für die Versuche wurde ein Kieselsol mit einem pH-Wert bei 22°C von 6,9 verwendet (Levasil® 50 CK / 30%-V2, Bayer AG, mittlere Teilchengröße 78-82 nm, Feststoffgehalt 30 Gew.-%).

**Tabelle 3:**

| Konzentration H₂O₂ / Vol.-% | KOH / g/L | Abtragsrate / Å/min | | |
|---|---|---|---|---|
| | | Cu | Ta | SiO₂ |
| 1 | 3,34 | 80 | 350 | 223 |
| 3 | 6,20 | 167 | 775 | 598 |
| 6 | 19,68 | 340 | 1216 | 1150 |
| 10 | 29,89 | 315 | 1875 | 1174 |

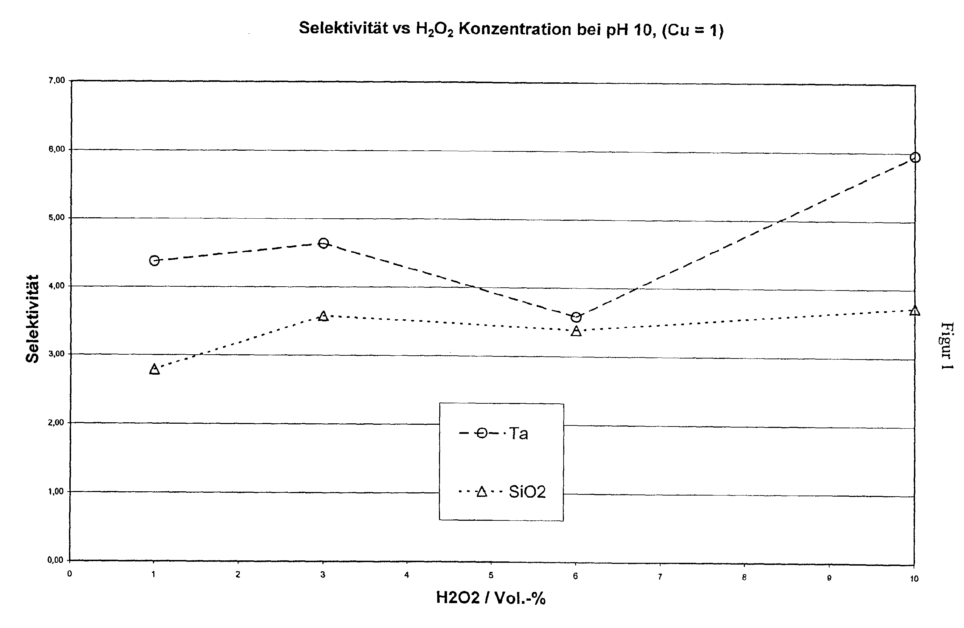

In Fig. 1 ist die Selektivität für Ta uns SiO₂ in Abhängigkeit von der Konzentration an H₂O₂ dargestellt, wobei die Selektivität für Cu jeweils 1 gesetzt ist.

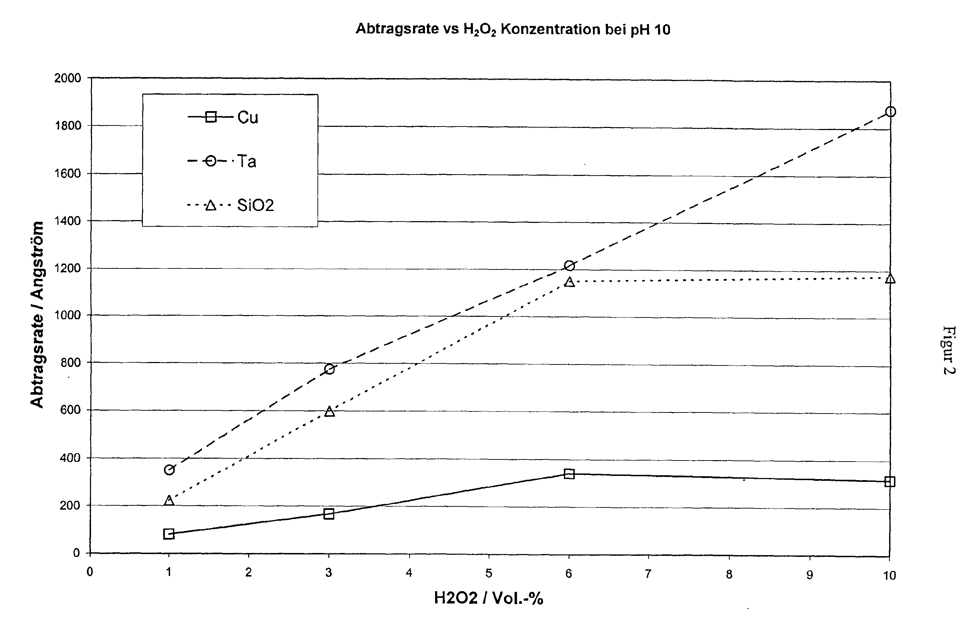

Fig. 2 zeigt die Abhängigkeit der Abtragsrate für Cu, Ta und SiO₂ von der Konzentration an H₂O₂.

### Beispiel 2

In dieser Versuchsreihe wurden Polierslurries mit 10 Vol.-% H₂O₂ hergestellt. Anschließend wurden die angegebenen Mengen KOH zugegeben, um einen pH-Wert von 2 - 10 zu erhalten, und eine Stunde gerührt. Nach der Herstellung der Polierslurries wurden die Wafer direkt poliert. Die KOH-Gehalte (100 %ig, bezogen auf 1 Liter Polierslurry ohne KOH-Zusatz) und die Abtragsraten sind in Tabelle 4 aufgeführt.

Für die Versuche mit den pH-Werten bei 22°C von 2 bis 4,6 wurde ein Kieselsol mit einem pH-Wert (22°C) von 2,1 verwendet (Levasil® 50 CK / 30%-V1, Bayer AG, mittlere Teilchengröße 78 nm, Feststoffgehalt 30 Gew.-%).

Für die Versuche mit den pH-Werten bei 22°C von 6,5 bis 10 wurde ein Kieselsol mit einem pH-Wert (22°C) von 6,9 verwendet (Levasil® 50 CK /30 %-V2, Bayer AG, mittlere Teilchengröße 78-82 nm, Feststoffgehalt 30 Gew.-%).

Teilweise wurden die Polierslurries zweimal hergestellt. Anschließend wurde direkt nach der Herstellung der Polierslurries mit diesen die Wafer poliert. Die Abtragsraten sind in Tabelle 4 aufgeführt.

**Tabelle 4**

| Polierslurry | KOH | Abtragsrate / Å/min | | | Selektivität | | |
|---|---|---|---|---|---|---|---|
| pH | g/L | Cu | Ta | SiO₂ | Cu | Ta | SiO₂ |
| 2 | - | 1300 | 990 | 487 | 1 | 0,76 | 0,37 |
| 2 | - | 1861 | 1178 | 825 | 1 | 0,63 | 0,44 |
| 3 | 0,001 | 776 | 759 | 261 | 1 | 0,98 | 0,34 |
| 4,1 | 0,045 | 594 | 340 | 247 | 1 | 0,57 | 0,42 |
| 4,6 | 0,12 | 717 | 632 | 430 | 1 | 0,88 | 0,60 |
| 6,5 | 0,18 | 107 | 552 | 208 | 1 | 5,16 | 1,94 |
| 6,7 | 0,24 | 110 | 573 | 337 | 1 | 5,21 | 3,06 |
| 8 | 2,4 | 119 | 681 | 328 | 1 | 5,76 | 2,76 |
| 8,8 | 7,1 | 110 | 633 | 393 | 1 | 5,75 | 3,57 |
| 8,8 | 7,2 | 219 | 1054 | 877 | 1 | 4,81 | 4,00 |
| 10 | 29,25 | 390 | 1859 | 1211 | 1 | 4,77 | 3,11 |
| 10 | 29,89 | 463 | 1814 | 1129 | 1 | 3,92 | 2,44 |

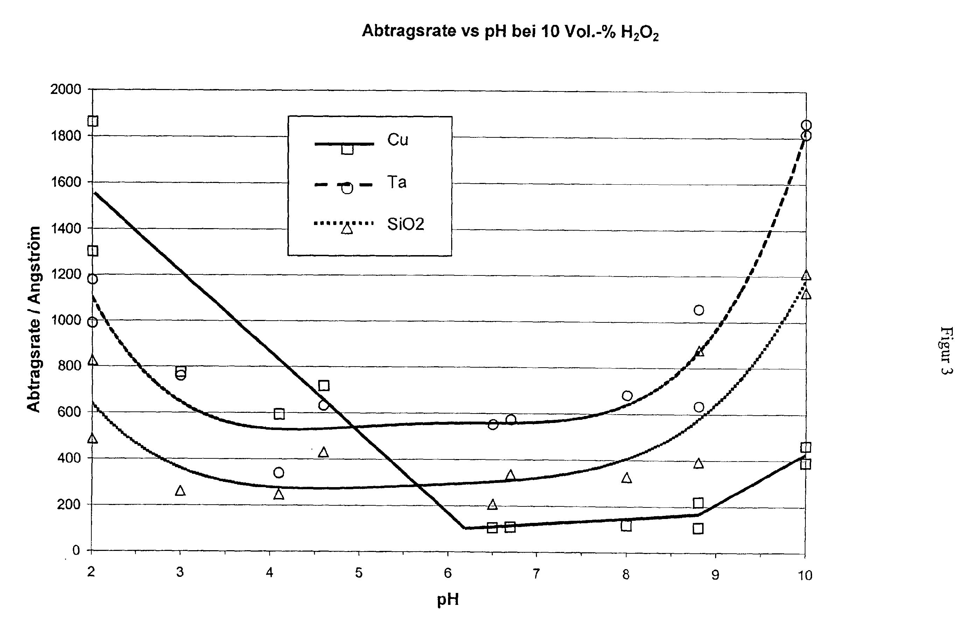

Fig. 3 zeigt die Abhängigkeit der Abtragsrate für Cu, Ta und SiO₂ vom pH-Wert (22°C).

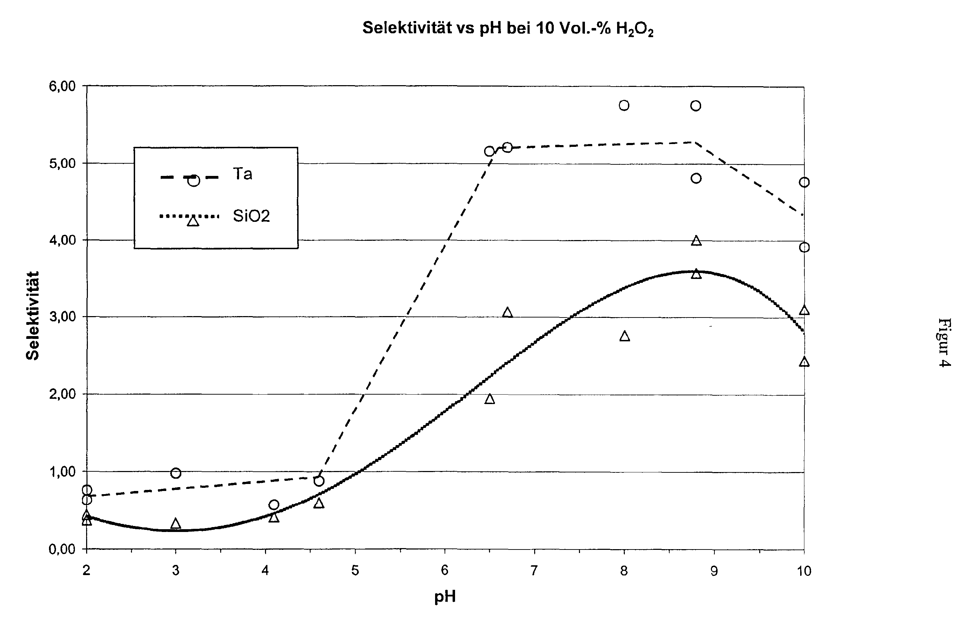

In Fig. 4 ist die Selektivität für Ta und SiO₂ in Abhängigkeit vom pH-Wert (22°C) dargestellt, wobei die Selektivität für Cu jeweils 1 gesetzt ist.

### Vergleichsbeispiel 1

In diesem Versuch wurde eine Polierslurry mit 10 Vol.-% H₂O₂ hergestellt. Die Feststoffkonzentration betrug 10 Gew.-%. Anschließend wurden 13,14 g KOH zugegeben um einen pH-Wert bei 22°C von 10 zu erhalten und eine Stunde gerührt. Nach der Herstellung der Polierslurry wurden die Wafer direkt poliert. Die Abtragsraten und die Selektivitäten sind in Tabelle 5 aufgeführt.

Für die Versuche wurde eine pyrogene Kieselsäure, die in Wasser dispergiert ist, mit einem pH-Wert bei 22°C von 11 verwendet. Der Feststoffgehalt betrug 25 Gew.-% (SS 25 der Fa. Cabot, USA).

**Tabelle 5**

| Abtragsrate / Å/min | | | Selektivität | | |
|---|---|---|---|---|---|
| Cu | Ta | SiO₂ | Cu | Ta | SiO₂ |
| 514 | 489 | 1500 | 1 | 0,95 | 2,92 |

### Vergleichsbeispiel 2

In diesem Versuch wurde eine Polierslurry mit 10 Vol.-% H₂O₂ hergestellt. Die Feststoffkonzentration betrug 3 Gew.-%. Anschließend wurde KOH zugegeben, um einen pH-Wert bei 22°C von 10 zu erhalten. Außerdem wurden der Polierslurry 0.001 M Benztriazolamin zugesetzt. Es wurde eine Stunde gerührt. Nach der Herstellung der Polierslurry wurden die Wafer direkt poliert. Die Abtragsraten und die Selektivitäten sind in Tabelle 6 aufgeführt.

Für die Versuche wurde ein γ-Aluminiumoxid der Fa. EXTEC, USA, Typ 16761 verwendet. Der d₅₀-Wert des γ-Aluminiumoxids betrug 240 nm, die BET-Oberfläche 100 m²/g. Das γ-Aluminiumoxid wurde in den 70 Vol.-% Wasser, die für den Ansatz benötigt werden, dispergiert.

**Tabelle 6**

| Abtragsrate / Å/min | | | Selektivität | | |
|---|---|---|---|---|---|
| Cu | Ta | SiO₂ | Cu | Ta | SiO₂ |
| 200 | 200 | 50 | 1 | 1 | 0,25 |

Aus den Vergleichsbeispielen ist ersichtlich, dass Polierslurries mit pyrogener Kieselsäure oder mit Aluminiumoxid als Abrasiv nicht die Selektivitäten aufweisen, die bei der Verwendung der erfindungsgemäßen Polierslurries gefunden werden.

## Patentansprüche

1. Polierslurry für das chemisch-mechanische Polieren von Metall- und Metall/Dielektrika-Strukturen, enthaltend 2,5 bis 70 Vol.-% eines durch H⁺oder K⁺-Ionen stabilisierten 15 bis 40 Gew.-% SiO₂ enthaltenden Kieselsols, dessen SiO₂-Partikel eine mittlere Teilchengröße kleiner als 300 nm haben, 6 bis 10 Vol.-% Wasserstoffperoxid und eine Base in einer Menge, um den pH-Wert bei 22°C der Polierslurry auf einen Wert von 5 bis 11,5 einzustellen.

2. Polierslurry nach Anspruch 1, **dadurch gekennzeichnet, dass** sie 1 bis 21,5 Gew.-% SiO₂ enthält.

3. Polierslurry nach Anspruch 1, **dadurch gekennzeichnet, dass** sie 8 bis 10 Vol.-% Wasserstoffperoxid enthält.

4. Polierslurry nach Anspruch 1, **dadurch gekennzeichnet, dass** sie Kaliumhydroxid als Base enthält.

5. Polierslurry nach Anspruch 1, **dadurch gekennzeichnet, dass** ihr pH-Wert bei 22°C im Bereich von 6 bis 10 liegt.

6. Verwendung der Polierslurry nach Anspruch 1 zum Polieren von Al, Ru, Pt, Ir, Cu, Ta, Ti, Si und W und/oder deren Legierungen, Nitride, Carbide, Oxide, Carbonitride, Oxinitride, Oxicarbide und Oxicarbonitride.

7. Verwendung der Polierslurry nach Anspruch 1 zum Polieren von SiLK™, Polyimiden, fluorierten Polyimiden, diamantartigen Kohlenstoffen, Polyarylethern, Polyarylenen, Parylen N, Cyclotenen, Polynorbonenen, Teflon, Silsesquioxanen oder SiO₂-Glas.

8. Verwendung der Polierslurry nach Anspruch 1 bei der Herstellung von Halbleitern, integrierten Schaltungen und microelektromechanischen Systemen.

9. Verfahren zur Herstellung einer Polierslurry für das chemisch-mechanische Polieren von Metall- und Metall/Dielektrika-Strukturen, enthaltend 2,5 bis 70 Vol.-% eines durch H⁺- oder K⁺-Ionen stabilisierten 15 bis 40 Gew.-% SiO₂ enthaltenden Kieselsols, dessen SiO₂-Partikel eine mittlere Teilchengröße kleiner als 300 nm haben, 6 bis 10 Vol.-% Wasserstoffperoxid und eine Base in einer Menge, um den pH-Wert bei 22°C der Polierslurry auf einen Wert von 5 bis 11,5 einzustellen, **dadurch gekennzeichnet ist, dass** beim Vermischen der Bestandteile die Zugabe des Wasserstoffperoxids zuletzt erfolgt.
